# EUROPÄISCHE PATENTSCHRIFT

(11) **EP 1 844 181 B1**
(45) Veröffentlichungstag und Bekanntmachung des Hinweises auf die Patenterteilung: **04.05.2016**
(21) Anmeldenummer: 06707897.2
(22) Anmeldetag: 30.01.2006
(51) Int. Cl.: C23C 24/04, H05K 3/10, H05K 3/14, B05B 7/14, B05B 7/16, B05B 7/22, B05B 15/12, B23K 26/00

(54) **VERFAHREN ZUM KALTGASSPRITZEN**
COLD GAS SPRAYING METHOD
PROCEDE DE PULVERISATION PAR GAZ FROID

(30) Priorität: 02.02.2005 DE 102005005359
(43) Veröffentlichungstag der Anmeldung: 17.10.2007
(73) Patentinhaber: Siemens Aktiengesellschaft, 80333 München (DE)
(72) Erfinder: JENSEN, Jens Dahl, 14050 Berlin (DE); KRÜGER, Ursus, 14089 Berlin (DE); ULLRICH, Raymond, 14621 Schönwalde (DE)
(86) Internationale Anmeldenummer: PCT/EP2006/050518
(87) Internationale Veröffentlichungsnummer: WO 2006/082170

(56) Entgegenhaltungen:
- EP-A- 1 382 719
- EP-A- 1 622 435
- WO-A-03/039407
- WO-A-03/070524
- DE-A1- 10 036 264
- PATENT ABSTRACTS OF JAPAN Bd. 2000, Nr. 07, 29. September 2000 (2000-09-29) & JP 2000 119835 A (AGENCY OF IND SCIENCE & TECHNOL; LASER OYO KOGAKU KENKYUSHO:KK), 25. April 2000 (2000-04-25)

## Beschreibung

Die Erfindung betrifft ein Verfahren zum Beschichten eines Werkstückes, bei dem Partikel eines Beschichtungsstoffes mittels einer Kaltgas-Spritzdüse zur zu beschichtenden Oberfläche des Werkstückes hin beschleunigt werden.

Ein derartiges Verfahren ist beispielsweise in der US 2004/0037954 A1 beschrieben. Nach diesem Verfahren werden die Partikel, die die Beschichtung bilden sollen, in einem so genannten Kaltgasstrahl zur Oberfläche des zu beschichtenden Bauteils hin beschleunigt. Dies erfolgt mittels einer Kaltgas-Spritzdüse. Dabei werden die Beschichtungspartikel mit einer genügenden kinetischen Energie beaufschlagt, damit auf der zu beschichtenden Oberfläche eine Schicht entsteht. Dabei wird die kinetische Energie einerseits in eine Verformung der Beschichtungspartikel und der Oberfläche umgewandelt, andererseits führt eine Umwandlung der kinetischen Energie in thermische Energie zu einem Aufschmelzen der Oberfläche des Werkstücks und der Beschichtungspartikel zumindest in den oberflächennahen Bereichen, so dass die Beschichtung eine fest haftende Struktur auf der Oberfläche des zu beschichtenden Werkstückes bildet.

Das beschriebene Verfahren wird auch als Kaltgasspritzen bezeichnet. Die Verwendung dieses Verfahren hat den Vorteil, dass die thermische Belastung der Beschichtungspartikel und des Substrates im Vergleich beispielsweise zum Plasmaspritzen gering gehalten werden kann, so dass das Gefüge der Beschichtungspartikel wenig oder gar nicht beeinflusst wird. Hierdurch lassen sich Beschichtungspartikel mit besonderen Eigenschaften für die Herstellung von Schichten verwenden, ohne dass die Eigenschaften der Beschichtungspartikel aufgrund einer thermischen Belastung derselben beeinträchtigt würde.

Gemäß der DE 600 09 823 T2 ist ein Verfahren zur Reparatur von Oberflächen mittels Kaltgasspritzen beschrieben. Die zu reparierenden Stellen der Oberfläche werden mit einem die Beschichtungspartikel enthaltenden Kaltgasstrahl behandelt, wodurch sich eine Schicht bildet. Der Energieeintrag in den Kaltgasstrahl kann erhöht werden, wenn die Beschichtungspartikel einer Strahlungsquelle, beispielsweise einem Laser, ausgesetzt werden. Hierdurch steigt die thermische Energie der Beschichtungspartikel, die durch die Beschleunigung in der Kaltgasspritzdüse keine wesentliche Temperaturerhöhung erfahren. Außerdem kann die ausgebildete Schicht einer Nachbehandlung unterworfen werden, die ebenfalls mittels eines Lasers erfolgen kann.

Gemäß dem Abstract zur JP 05078812A ist vorgesehen, dass eine Schicht durch thermisches Spritzen hergestellt werden kann und anschließend mittels eines Lasers nachbehandelt werden kann, um die endgültige Schichtzusammensetzung zu erzeugen. Ebenso kann gemäß der DE 199 41 562 A1 eine Beschichtung beispielsweise als Lauffläche für Zylinder erzeugt werden, welche als thermische Spritzschicht hergestellt wird und mittels eines Laserstrahls anschließend umgeschmolzen wird, wodurch die gewünschte Gefügezusammensetzung entsteht.

Gemäß der DE 197 40 205 B4 ist es beim Plasmaspritzen auch möglich, mittels eines Lasers die Abkühlung der durch das Plasmaspritzen aufgebrachten Beschichtung zu verlangsamen, um die Ausbildung des Gefüges der Beschichtung direkt zu beeinflussen. Zu diesem Zweck werden die aufgetroffenen Teilchen des Spritzstrahls für eine Zeit lang noch auf Schmelztemperatur gehalten.

Gemäß der DE 100 36 264 A1 wird vorgeschlagen, dass ein Beschichtung durch Kaltgasspritzen hergestellt werden kann. Sobald diese Schicht fertig gestellt ist, kann durch einen weiteren Energieeintrag beispielsweise mit einem Laser erreicht werden, dass diese gebildete Beschichtung nachträglich chemisch verändert wird. Dabei kann auch eine Wechselwirkung zwischen dem Substrat und der Schicht zu chemischen Reaktionen zwischen Schichtbestandteilen und Substratbestandteilen führen.

Gemäß der WO 03/070524 A1 ist es außerdem bekannt, dass die Nachbehandlung einer fertig gestellten Schicht mittels eines Energieeintrags dazu verwendet werden kann, die Schichtbestandteile allein zu beeinflussen. Hierbei können die Schichteigenschaften verändert werden, ohne dass das Substrat hiervon betroffen wird. Dies lässt sich auch erreichen, wenn die Schicht in Form von Leiterbahnen aufgebracht wird, die bereichsweise nur unvollständig auf dem Substrat haften, um einen Toleranzausgleich bei einer thermischen Beanspruchung des Bauteils mit den Leiterbahnen zu erreichen.

Die Aufgabe der Erfindung liegt darin, ein Verfahren zum Beschichten von Werkstücken mittels Kaltgas-Spritzdüse dahingehend zu verbessern, dass mit diesem Verfahren ein möglichst großer Spielraum bei der Herstellung der Schichten erzeugt wird.

Diese Aufgabe wird erfindungsgemäß mit dem eingangs genannten Verfahren dadurch gelöst, dass die Partikel im Kaltgasstrahl mit einer Energiemenge beaufschlagt werden, die zu gering ist, um eine bleibende Haftung der Partikel auf der Oberfläche hervorzurufen und dass eine bleibende Haftung der Partikel während des Beschichtens durch einen lokalen Eintrag von elektromagnetischer Strahlung in die Auftreffstelle des Kaltgasstrahles auf die Oberfläche erzeugt wird. Bei der erfindungsgemäßen Ausgestaltung des Verfahrens wird die Kaltgas-Spritzdüse also mit Verfahrensparametern betrieben, die bewusst so gewählt werden, dass durch das Kaltgasspritzen allein keine Beschichtung entsteht, deren Eigenschaften bereits dem gewünschten Endprodukt der Beschichtung entsprechen. Mit anderen Worten ist der durch das Kaltgasspritzen erzeugte Energieeintrag zur Erzeugung der gewünschten Schicht nicht ausreichend. Erfindungsgemäß wird daher eine weitere Energiequelle vorgesehen, die einen lokalen Eintrag von elektromagnetischer Strahlung in die Oberfläche, genauer in dem Bereich der Beschichtung ermöglicht, deren Eigenschaften abschließend durch den zusätzlichen Energieeintrag der elektromagnetischen Strahlung erzeugt werden können. Hierdurch ist es vorteilhaft möglich, den Energieeintrag durch die Kaltgas-Spritzdüse vergleichsweise gering zu halten, so dass Partikel mit vergleichsweise niedrigem Schmelzpunkt für die Beschichtung verwendet werden können. Außerdem ist es durch den lokalen Energieeintrag der elektromagnetischen Strahlung auf der Oberfläche des beschichteten Werkstückes möglich, in Abhängigkeit vom Betrag des lokalen Energieeintrages Schichten mit lokal sich verändernden Eigenschaften zu erzeugen. Hierbei ist vorteilhaft eine hohe Genauigkeit der lokalen Änderung der Schichteigenschaft erzeugbar.

Erfindungsgemäß ist vorgesehen, dass die Energiemenge im Kaltgasstrahl groß genug ist, um eine vorläufige Haftung der Partikel hervorzurufen, wobei nach dem lokalen Erzeugen einer bleibenden Haftung bestimmter Partikel die restlichen, vorläufig anhaftenden Partikel wieder von der Oberfläche entfernt werden. Eine vorläufige Haftung der Partikel ist dadurch zu erreichen, dass deren kinetische Energie gerade ausreicht, dass die Beschichtungspartikel auf der Oberfläche anhaften. Der hierzu notwendige Energieeintrag kann durch das verwendete Verfahren des Kaltgasspritzens sehr genau eingestellt werden. Andererseits ist die Haftung der Partikel nicht groß genug, dass eine mögliche Verschmelzung von Werkstück und Partikeln stattfinden würde. Dadurch können die vorläufig anhaftenden Partikel wieder von der Oberfläche entfernt werden, wobei im Wesentlichen eine Trennung zwischen den Grenzflächen des Werkstückes und der Partikel erfolgt (beispielsweise mechanisch, durch Sandstrahlen oder Laserablation). Durch den zusätzlichen Energieeintrag kann jedoch lokal eine bleibende Haftung der hierfür vorgesehenen Partikel erreicht werden. Der Energieeintrag führt nämlich zu einer endgültigen Auflösung der Grenzflächen zwischen den betreffenden Partikeln und der Oberfläche oder auch zwischen den Grenzflächen benachbarter Partikel, so dass diese nicht mehr voneinander getrennt werden können. Dabei werden beispielsweise die grenzschichtnahen Bereiche von Werkstück und Partikeln aufgeschmolzen, so dass nach der Erstarrung ein einheitliches Gefüge entsteht.

Den beschriebenen Ausgestaltungen des erfindungsgemäßen Verfahrens ist gemeinsam, dass der zur Herstellung der Schicht notwendige Energieeintrag in die Partikel zu wesentlichen Teilen einerseits auf die Kaltgas-Spritzdüse und andererseits auf die Energiequelle für die elektromagnetische Strahlung (beispielsweise einen Laser) aufgeteilt wird. Hierdurch schafft das erfindungsgemäße Verfahren vorteilhaft einen größeren Spielraum zur Veränderung der Verfahrensparameter. Einerseits ist durch die Ausrichtung der Kaltgas-Spritzdüse eine verhältnismäßig genaue Ausrichtung des Teilchenstrahls auf der Oberfläche des Werkstückes möglich, andererseits lässt sich die Energiequelle für die elektromagnetische Strahlung unabhängig von der Kaltgas-Spritzdüse sehr genau ausrichten, so dass ein Schichtaufbau mit hochgenauer Geometrie ermöglicht wird.

Es ist zwar beispielsweise aus der US 4,724,299 grundsätzlich bekannt, bei so genannten Lasercladdingverfahren elektromagnetische Strahlung zu verwenden, um Beschichtungspartikel aufzuschmelzen, jedoch erfolgt der den Schichtaufbau bestimmende Energieeintrag bei diesem Verfahren ausschließlich durch den Laserstrahl, da sie kinetische Energie der Partikel aufgrund der Partikelzuführung vernachlässigt werden kann. Diese soll lediglich einen gleichmäßigen Transport der Beschichtungspartikel sicherstellen. Dies erklärt auch den standardmäßig verwendeten Ringaufbau der Zuführungsvorrichtung für die Beschichtungspartikel, die bei Lasercladdingverfahren zur Anwendung kommen, da der Laser im Zentrum erzeugt werden soll und eine Zuführung der Partikel aufgrund ihrer geringen kinetischen Energie sehr nahe am Fokuspunkt des Lasers erfolgen muss.

Gemäß einer zusätzlichen Ausgestaltung des Verfahrens ist vorgesehen, dass die Energiemenge, mit der die Partikel beaufschlagt werden, neben einem aufgrund ihrer Beschleunigung in der Kaltgas-Spritzdüse erzeugten kinetischen Energiebetrag auch einen thermischen Energiebetrag aufweist, der durch eine zusätzliche Energiequelle im Kaltgasstrahl erzeugt wird. Eine gewisse Erwärmung der Partikel in der Kaltgas-Spritzdüse unterhalb der Schmelztemperatur der Partikel führt dazu, dass die durch die elektromagnetische Strahlung einzubringende Energie verringert wird. Hierdurch entsteht vorteilhaft ein weiterer Verfahrensparameter, über den der Schichtaufbau beeinflusst werden kann.

Es ist besonders vorteilhaft, wenn ein elektrisch isolierendes Werkstück verwendet wird und mit der elektromagnetischen Strahlung auf dem Werkstück aus den Partikeln elektrisch leitfähige Leiterbahnen hergestellt werden. Auf diese Weise ist es vorteilhaft möglich, beispielsweise auf nicht leitenden Oberflächen mit komplexer Geometrie Leiterbahnen für elektronische Schaltungsaufbauten herzustellen. Die verwendeten Partikel können beispielsweise elektrisch leitfähiges Material enthalten, welches erst durch die Behandlung mittels der elektromagnetischen Strahlung aktiviert wird, wodurch die Leitfähigkeit hergestellt wird. Zusätzlich können die elektrisch leitfähigen Bereiche der Beschichtung zur Verbesserung der elektrischen Eigenschaften beispielsweise galvanisch beschichtet werden, da diese hierfür einen elektrisch leitfähigen Untergrund zur Verfügung stellen.

Weiterhin ist es vorteilhaft, zur Erzeugung der elektromagnetischen Strahlung einen Laser zu verwenden. Dieser ermöglicht die sehr lokale Einbringung elektromagnetischer Strahlung in die zu bildende Schicht. Dies ist auch bei komplexen Oberflächengeometrien des zu beschichtenden Bauteils möglich.

Weitere Einzelheiten der Erfindung werden im Folgenden anhand der Zeichnung beschrieben. In den einzelnen Figuren sind gleiche oder sich entsprechende Bauteile mit jeweils den gleichen Bezugszeichen versehen und werden nur insoweit mehrfach erläutert, wie sich Unterschiede zwischen den einzelnen Figuren ergeben. Es zeigen
- Figur 1: ein Ausführungsbeispiel der erfindungsgemäßen Beschichtungsanlage als Schemazeichnung,
- Figur 2: den Bereich der Energiebeaufschlagung der Partikel bei Einsatz eines Lasers im Vergleich zu dem Bereich, der beim Kaltgasspritzen gemäß dem Stand der Technik angewendet wird, qualitativ und die
- Figuren 3 bis 5: ausgewählte Verfahrensschritte von Ausführungsbeispielen des erfindungsgemäßen Verfahrens, bei denen die Partikel auf der Oberfläche nicht anhaften, vorläufig anhaften oder aufgrund der Behandlung mit einem Laser endgültig anhaften.

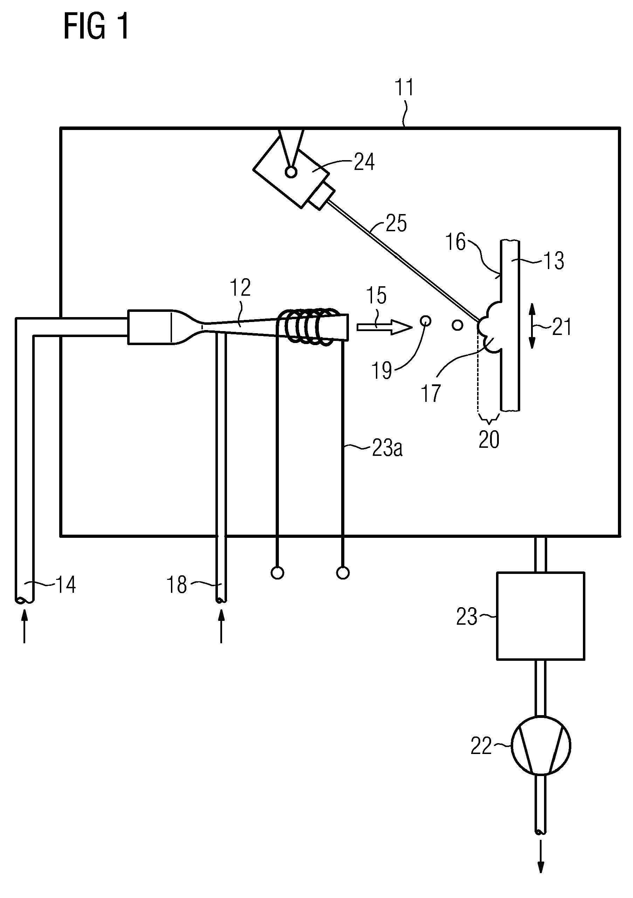

Dargestellt in Figur 1 ist eine modifizierte Vorrichtung zum Kaltgasspritzen. Diese weist einen Vakuumbehälter 11 auf, in dem einerseits eine Kaltgas-Spritzdüse 12 und andererseits ein Werkstück 13 angeordnet sind (Befestigung nicht näher dargestellt). Durch eine erste Leitung 14 kann ein Prozessgas der Kaltgas-Spritzdüse 12 zugeführt werden. Diese ist, wie durch die Kontur angedeutet, als Laval-Düse ausgeführt, durch die das Prozessgas entspannt und in Form eines Gasstrahls (Pfeil 15) zu einer Oberfläche 16 des Substrats 13 hin beschleunigt wird. Das Prozessgas kann als reaktives Gas Sauerstoff 17 enthalten. Weiterhin kann das Prozessgas in nicht dargestellter Weise erwärmt werden, wodurch sich in dem Vakuumbehälter 12 eine geforderte Prozesstemperatur einstellt.

Durch eine zweite Leitung 18 können der Kaltgas-Spritzdüse 12 Partikel 19 zugeführt werden, die in dem Gasstrahl beschleunigt werden und auf die Oberfläche 16 auftreffen. Die kinetische Energie der Partikel führt zu einem Anhaften derselben auf der Oberfläche 16, wobei eventuell auch der Sauerstoff 17 in die sich ausbildende Schicht 20 eingebaut wird. Zur Ausbildung der Schicht kann das Substrat 13 in Richtung des Doppelpfeils 21 vor der Kaltgas-Spritzpistole 12 hin und her bewegt werden. Während dieses Beschichtungsprozesses wird das Vakuum im Vakuumbehälter 11 durch eine Vakuumpumpe 22 ständig aufrechterhalten, wobei das Prozessgas vor Durchleitung durch die Vakuumpumpe 22 durch einen Filter 23 geführt wird, um Partikel auszufiltern, die beim Auftreffen auf die Oberfläche 16 nicht an diese gebunden wurden.

Mittels einer Heizung 23 können die Partikel 19 innerhalb der Kaltgas-Spritzdüse zusätzlich erwärmt werden. Hierdurch erfolgt ein zusätzlicher Energieeintrag, der direkt als thermische Energie oder durch eine Entspannung in der Laval-Düse in Form von kinetischer Energie dem Partikel 19 zugeführt wird. Als weitere Energiequelle ist ein Laser 24 in der Vakuumkammer 11 installiert, der auf die Auftreffstelle des Kaltstrahls auf die Oberfläche 16 des Werkstückes 13 gerichtet ist. An der Auftreffstelle sorgt die elektromagnetische Energie des Laserstrahls in Verbindung mit der kinetischen und eventuell thermischen Energie der Partikel 19 für ein bleibendes Anhaften der Partikel 19 auf der Oberfläche 16, wodurch die Schicht 20 ausgebildet wird.

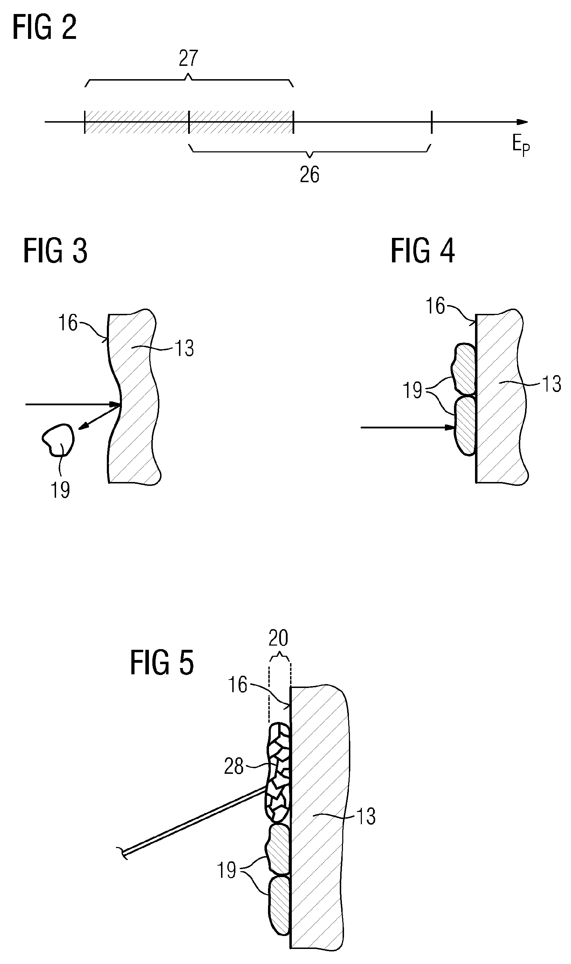

In Figur 2 ist die Energie Eₚ, mit der die Beschichtungspartikel beaufschlagt werden, graphisch dargestellt. Diese Energie besteht aus der kinetischen Energie der Partikel im Kaltgasstrahl sowie einer eventuellen Komponente aufgrund einer thermischen Energie. Zu erkennen ist ein Bereich 26, der für das Kaltgasspritzverfahren gemäß dem Stand der Technik zum Einsatz kommt. Dieser Bereich ist nach oben begrenzt durch das Aufschmelzen der Partikel, welches beim Kaltgasspritzen nicht vorgesehen ist. Ein eventuelles Anschmelzen der Partikeloberfläche kann eventuell noch hingenommen werden. Nach unten die der Bereich dadurch begrenzt, dass die Partikel bei Unterschreiten eines bestimmten Energiebetrages Eₚ nicht mehr an der zu beschichtenden Oberfläche haften bleiben, sondern wieder abspringen (vgl. Figur 3). Zu erkennen ist weiterhin schraffiert ein Bereich 27, der eine Eignung für die Durchführung des erfindungsgemäßen Verfahrens beinhaltet. Dieser Bereich überschneidet sich mit dem unteren Teil des Bereiches 26. Die Obergrenze des Bereiches 27 ist dadurch gegeben, dass die Energie Eₚ zu groß wird, um noch ein vorläufiges Anhaften der Partikel auf der zu beschichtenden Oberfläche zu gewährleisten, d. h. die Möglichkeit einer anschließenden Entfernung der Teilchen zu beinhalten. Die untere Grenze wird durch die Leistung des Erzeugers für elektromagnetische Strahlung definiert, da Eₚ ausreichen muss, um gemeinsam mit dem Energieeintrag durch die elektromagnetische Strahlung die Ausbildung einer Schicht zu gewährleisten. Wie aus Figur 2 deutlich wird, ist der Bereich für Eₚ des erfindungsgemäßen Verfahrens im Bezug auf das Kaltgasspritzen gemäß dem Stand der Technik zu geringeren Energien verschoben.

In der Figur 3 ist ein einzelnes Partikel 19 zu erkennen, dessen kinetische Energie nicht ausreicht, um zumindest eine vorläufige Haftung auf der Oberfläche 16 des Werkstückes 13 zu erzielen. Es prallt daher von der Oberfläche 16 ab, wobei diese eine daraus resultierende Verformung erfährt. In Figur 2 ist der Vorgang gemäß Figur 3 durch den Bereich 27 außerhalb des Bereiches 26 angedeutet.

In Figur 4 prallen die Teilchen 19 mit einer genügenden kinetischen Energie auf die Oberfläche 16 des Werkstückes 13, das eine vorläufige Haftung bewirkt wird. Eine Verbindung der Partikel 19 mit der Oberfläche 16 ist allerdings noch schwach, so dass die Partikel 19 von der Oberfläche 16 wieder entfernt werden können. Der Vorgang gemäß Figur 4 liegt gemäß Figur 2 in dem Überschneidungsbereich von den Bereichen 27 und 26.

In Figur 5 ist schematisch dargestellt, wie der Laserstrahl 25 einzelne Partikel 19 mit einem genügenden Energiebetrag versorgt, dass diese zu einer Schicht 20 mit dem Werkstück 13 verschmelzen. Hierbei bildet sich ein neues Gefüge, welches durch Korngrenzen 28 angedeutet ist.

## Patentansprüche

1. Verfahren zum Beschichten eines Werkstückes (13), bei dem Partikel (19) eines Beschichtungsstoffes mittels einer Kaltgas-Spritzdüse (12) zur zu beschichtenden Oberfläche (16) des Werkstückes (13) hin beschleunigt werden,
**dadurch gekennzeichnet,**
**dass** die Partikel im Kaltgasstrahl (15) mit einer Energiemenge beaufschlagt werden, die zu gering ist, um eine bleibende Haftung der Partikel (19) auf der Oberfläche (16) hervorzurufen, jedoch die kinetische Energie der Partikel ausreicht, um eine vorläufige Haftung auf der Oberfläche zu erzeugen, so dass vorläufig anhaftende Partikel wieder vor der Oberfläche entfernt werden können, und dass eine bleibende Haftung der Partikel während des Beschichtens durch einen lokalen Eintrag von elektromagnetischer Strahlung (25) in die Auftreffstelle des Kaltgasstrahles auf die Oberfläche erzeugt wird, wobei die Partikel durch einen Laserstrahl (24) mit einer genügenden Energiemenge beaufschlagt werden, damit diese mit dem Werkstück (13) verschmelzen.

2. Verfahren nach Anspruch 1
**dadurch gekennzeichnet,**
**dass** die Energiemenge, mit der die Partikel beaufschlagt werden, neben einem auf Grund ihrer Beschleunigung in der Kaltgas-Spritzdüse (12) erzeugten kinetischen Energiebetrag auch einen thermischen Energiebetrag aufweist, der durch eine zusätzliche Energiequelle (23a) im Kaltgasstrahl (15) erzeugt wird.

3. Verfahren nach einem der voranstehenden Ansprüche,
**dadurch gekennzeichnet,**
**dass** ein Werkstück mit elektrisch isolierender Oberfläche verwendet wird und mittels der elektromagnetischen Strahlung (25) auf dem Werkstück aus den Partikeln elektrisch leitfähige Leiterbahnen hergestellt werden.

## Claims

1. Method for coating a workpiece (13) in which particles (19) of a coating material are accelerated by means of a cold gas spray nozzle (12) toward the surface (16) of the workpiece (13) that is to be coated, **characterized in that** the particles in the cold gas jet (15) are subjected to an amount of energy that is too small to cause permanent adherence of the particles (19) on the surface (16), but the kinetic energy of the particles is adequate for producing temporary adherence on the surface, so that temporarily adhering particles can be removed again from the surface, and **in that** permanent adherence of the particles is produced during the coating by locally introducing electromagnetic radiation (25) into the point of impingement of the cold gas jet on the surface, wherein the particles are subjected by means of a laser beam (24) to a sufficient amount of energy that they fuse with the workpiece (13).

2. Method according to Claim 1, **characterized in that** the amount of energy to which the particles are subjected comprises not only an amount of kinetic energy, produced by their acceleration in the cold gas spray nozzle (12), but also an amount of thermal energy, produced by an additional energy source (23a) in the cold gas jet (15).

3. Method according to one of the preceding claims, **characterized in that** a workpiece with an electrically insulating surface is used and electrically conductive strip conductors are produced from the particles on the workpiece by means of the electromagnetic radiation (25).

## Revendications

1. Procédé de revêtement d'une pièce ( 13 ), dans lequel on accélère des particules ( 19 ) d'une substance de revêtement au moyen d'une buse ( 12 ) de pulvérisation à gaz froid vers la surface ( 16 ) à revêtir de la pièce ( 13 ),
**caractérisé**
**en ce que** l'on envoie les particules dans le jet ( 15 ) de gaz froid avec une quantité d'énergie qui est trop petite pour provoquer une adhérence permanente des particules ( 19 ) à la surface ( 16 ), mais l'énergie cinétique des particules suffit pour produire une adhérence temporaire à la surface de manière à pouvoir retirer de la surface des particules adhérant provisoirement, et en ce que l'on produit une adhérence persistante des particules pendant le revêtement par un apport local de rayonnement ( 25 ) électromagnétique au point d'incidence du jet de gaz froid sur la surface, les particules étant envoyées par un faisceau ( 24 ) laser en une quantité d'énergie suffisante afin de les fusionner avec la pièce ( 13 ).

2. Procédé suivant la revendication 1,
**caractérisé**
**en ce que** la quantité d'énergie avec laquelle les particules sont envoyées a, outre une composante d'énergie cinétique produite en raison de leur accélération dans la buse ( 12 ) de pulvérisation à gaz froid, une composante d'énergie thermique produite par une source ( 23a ) d'énergie supplémentaire dans le jet ( 15 ) de gaz froid.

3. Procédé suivant l'une des revendications précédentes,
**caractérisé**
**en ce qu'**on utilise une pièce ayant une surface isolante électriquement et on produit, au moyen du rayonnement ( 25 ) électromagnétique, sur la pièce des pistes conductrices de l'électricité en les particules.
